Europäisches Patentamt

European Patent Office

Office européen des brevets

(19)

(11) Veröffentlichungsnummer: **0 075 103**
A2

(12) **EUROPÄISCHE PATENTANMELDUNG**

(21) Anmeldenummer: 82107297.2

(22) Anmeldetag: 11.08.82

(51) Int. Cl.³: **H 01 L 29/743**, H 01 L 29/04, H 01 L 29/06, H 01 L 21/306

(30) Priorität: 22.09.81 DE 3137675

(43) Veröffentlichungstag der Anmeldung: 30.03.83 Patentblatt 83/13

(84) Benannte Vertragsstaaten: **CH FR GB IT LI NL SE**

(71) Anmelder: **SIEMENS AKTIENGESELLSCHAFT, Berlin und München Wittelsbacherplatz 2, D-8000 München 2 (DE)**

(72) Erfinder: **Herberg, Helmut, Dr., Kobellstrasse 12, D-8000 München 2 (DE)**

(54) **Thyristor mit einem Mehrschichten-Halbleiterkörper und Verfahren zu seiner Herstellung.**

(57) Die Erfindung bezieht sich auf einen Thyristor mit einem Mehrschichten-Halbleiterkörper (1) mit pnpn-Schichtfolge und mit zwei Grenzflächen (6, 8), die zu den pn-Übergängen zwischen den Schichten (2 bis 5) im wesentlichen parallel liegen. Angestrebt wird, die lateralen Randzonen des Thyristors so auszubilden, daß sie ohne eine mechanische Bearbeitung des Thyristor-Halbleiterkörpers herstellbar sind. Erfindungsgemäß wird dies dadurch erreicht, daß die genannten Grenzflächen {100}-orientiert sind und daß von einer derselben (6) V-förmige Gräben (13) ausgehen, die in <110>-Richtungen verlaufen und wenigstens einen der beiden von dieser Grenzfläche (6) weiter entfernten pn-Übergänge (14, 23) erreichen oder unterbrechen, wobei die Wandungen der Gräben (13) aus {111}-orientierten Halbleiterflächen bestehen. Die Gräben (13) werden durch anisotrope Ätzung erhalten. Der Anwendungsbereich umfaßt Leistungsthyristoren.

SIEMENS AKTIENGESELLSCHAFT     Unser Zeichen
Berlin und München            VPA  81 P 7 1 2 3 E

Thyristor mit einem Mehrschichten-Halbleiterkörper und Verfahren zu seiner Herstellung

Die Erfindung bezieht sich auf einen Thyristor mit einem Mehrschichten-Halbleiterkörper nach dem Oberbegriff des Anspruchs 1 sowie auf Verfahren zu seiner Herstellung.

Thyristoren dieser Art sind z.B. aus dem Buch "Thyristor Physics" von Adolph Blicher, Springerverlag, New York 1976, Seiten 198 bis 200, insbesondere Fig. 14.1, bekannt. Der abgeschrägte Rand des Halbleiterkörpers eines solchen Thyristors wird beispielsweise durch einen Schleifvorgang oder durch die Einwirkung eines zu den Grenzflächen schräg geführten Sandstrahls erzeugt. Anschließend muß jedoch der abgeschrägte Rand einem Ätzvorgang unterzogen werden, um die durch die genannten Bearbeitungsvorgänge entstandenen Kurzschlüsse, die die pn-Übergänge überbrücken, zu beseitigen.

Der Erfindung liegt die Aufgabe zugrunde, einen Thyristor der eingangs genannten Art anzugeben, der in einfacher Weise, d.h. ohne die genannten mechanischen Bearbeitungsvorgänge, herstellbar ist, wobei die Randbehandlung u.U. bereits an der ganzen Siliziumscheibe, d.h. an vielen Thyristoren gleichzeitig durchführbar ist. Das wird erfindungsgemäß durch eine Ausbildung des Thyristors gemäß dem kennzeichnenden Teil des Patentanspruchs 1 erreicht.

Der mit der Erfindung erzielbare Vorteil besteht insbesondere darin, daß der abgeschrägte Rand des Thyristor-Halbleiterkörpers ohne Schleifen oder Sandstrahlen hergestellt werden kann und daß die Herstellung der Randgeo-

St 1 The - 10. Sept. 1918

0075103

metrie so erfolgt, daß kein nachfolgender Arbeitsgang zur Beseitigung von randseitigen Kurzschlüssen erforderlich ist.

Die Ansprüche 2 bis 9 sind auf vorteilhafte Verfahren zur Herstellung eines Thyristors nach der Erfindung gerichtet.

Die Erfindung wird nachfolgend an Hand der Zeichnung näher erläutert. Dabei zeigt:

Fig. 1 einen nach der Erfindung ausgebildeten Thyristor,
Fig. 2 eine Draufsicht auf einen Teil eines scheibenförmigen Mehrschichten-Halbleiterkörpers, aus dem eine Mehrzahl von nach der Erfindung ausgebildeten Thyristor-Halbleiterkörpern herausgetrennt werden und
Fig. 3 einen Schnitt längs der Linie III-III von Fig. 2.

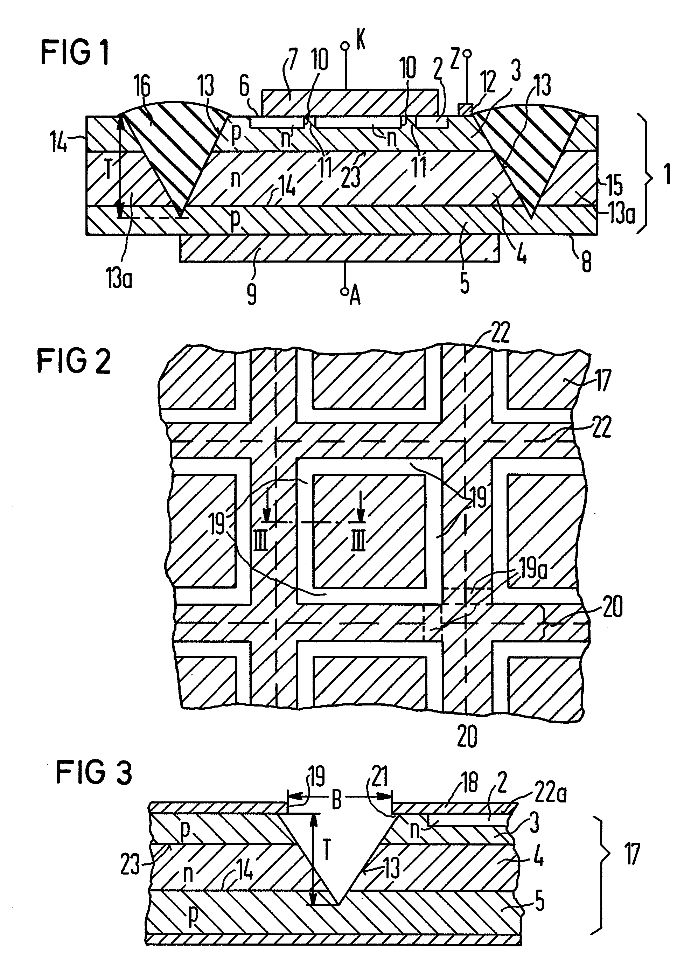

In Fig. 1 ist ein nach der Erfindung ausgebildeter Thyristor im Querschnitt dargestellt. Er weist einen Körper 1 aus monokristallinem Halbleitermaterial, z.B. Silizium, auf, der n-leitende Schichten 2 und 4 und p-leitende Schichten 3 und 5 enthält. Die Schicht 2 wird auch als n-Emitter bezeichnet, die Schicht 3 als p-Basis, die Schicht 4 als n-Basis und die Schicht 5 als p-Emitter. Der n-Emitter 2 ist an einer Grenzfläche 6 des Halbleiterkörpers mit einer Kathode 7 aus elektrisch leitendem Material, z.B. Aluminium, versehen, die einen Anschluß K aufweist, während der p-Emitter 5 in der gegenüberliegenden Grenzfläche 8 des Halbleiterkörpers von einer Anode 9 aus elektrisch leitendem Material, z.B. Aluminium, kontaktiert wird. Die Anode 9 ist mit einem Anschluß A verbunden. Mit 10 sind Ausnehmungen des n-Emitters 2 bezeichnet, die von Ansätzen 11 der p-Basis ausgefüllt sind. Letztere werden an der Grenzfläche 6 von der Kathode 7 kontaktiert. Man bezeichnet die Ansätze 11 auch als Emitter-Kurzschlüsse. Eine Zündelektrode 12, die mit dem Anschluß Z eines Zündstromkreises verbunden ist, kontaktiert die p-Basis 3.

Die Grenzflächen 6 und 8 sind {100}-orientierte Halbleiterflächen. Von der oberen Grenzfläche 6 gehen V-förmige Gräben 13 aus, deren Tiefe T so bemessen ist, daß sie dem Abstand des pn-Übergangs 14 zwischen der n-Basis 4 und dem p-Emitter 5 von der Grenzfläche 6 entspricht oder diesen übersteigt. Insbesondere kann die Tiefe T auch so bemessen sein, daß sie der Dicke des Halbleiterkörpers 1 entspricht. Ist für einen Thyristor nur Sperrfähigkeit in Blockierrichtung erforderlich (z.B. für einen asymmetrischen Thyristor), so genügt es, wenn die Grabentiefe T dem Abstand des pn-Übergangs 23 zwischen der p-Basis 3 und der n-Basis 4 von der Grenzfläche 6 entspricht oder diesen übersteigt. Die Gräben 13 verlaufen innerhalb der Grenzfläche 6 in den ⟨110⟩-Richtungen des Halbleiterkörpers. Vier solcher Gräben schließen denjenigen Teil der Grenzfläche 6 zwischen sich ein, der den für die Thyristorfunktionen wirksamen Teil des Thyristor-Halbleiterkörpers einseitig begrenzt. Die in Fig. 1 gezeigten Gräben 13 verlaufen senkrecht zur Bildebene, während zwei weitere Gräben, die bei dieser Darstellung nicht sichtbar sind, vor und hinter der Bildebene liegen und zu dieser parallel verlaufen. Außerhalb der Gräben 13 befindet sich eine für die Thyristorfunktionen nicht relevante Randzone 13a des Halbleiterkörpers 1, die durch Trennflächen 14, 15 seitlich abgeschlossen wird. Zweckmäßigerweise verlaufen die Trennflächen 14, 15 jeweils parallel zur Längsrichtung der Gräben 13 und bilden zusammen mit zwei weiteren Flächen, die vor und hinter der Bildebene von Fig. 1 liegen, eine rechteckförmige seitliche Begrenzung des Halbleiterkörpers 1. Die Wandungen der Gräben, z.B. 13,

0075103

bestehen aus {111}-Halbleiterflächen.

Zweckmäßigerweise sind die Gräben, z.B. 13, mit einer Passivierungsmasse 16, insbesondere Kautschuk, aufgefüllt. Die Passivierungsmasse wirkt dabei oberflächenseitigen Spannungsdurchbrüchen, die beim Anlegen von hohen Sperr- oder Blockierspannungen zwischen A und K im Bereich der inneren Wandungen der Gräben 13 auftreten können, entgegen. Durch die Passivierungsmasse 16 werden die Spannungsfestigkeiten des Thyristors, d.h. die Sperr- und Blockierspannungen, bei denen diese Spannungsdurchbrüche auftreten, wesentlich erhöht.

Wird die Tiefe T der Gräben 13 so bemessen, daß sie der Dicke des Halbleiterkörpers 1 entspricht, so entfällt die außerhalb der Gräben 13 liegende Randzone 13a einschließlich der äußeren Wandungsteile der Gräben.

Die Funktionsweise des Thyristors nach Fig. 1 entspricht der von herkömmlichen Thyristoren und ist beispielsweise in dem Buch von S.M. Sze "Physics of Semiconductor Devices", Verlag John Wiley & Sons, New York, 1969, Seiten 320 bis 340, beschrieben. Eine Beschreibung der Wirkungsweise der Emitter-Kurzschlüsse 11 ist der US-Patentschrift 4 079 406 entnehmbar.

In Fig. 2 ist ein Mehrschichten-Halbleiterkörper 17 in Draufsicht dargestellt, aus dem mehrere Thyristoren nach Fig. 1 hergestellt werden können. Er weist eine Schichtenfolge 2, 3, 4, 5 entsprechend Fig. 1 auf, wie aus dem entlang der Linie III-III verlaufenden, in Fig. 3 dargestellten Querschnitt hervorgeht. Die in Fig. 2 sichtbare, obere Grenzfläche 22a des Halbleiterkörpers 17 wird ebenso wie seine untere Grenzfläche mit einer schraffiert dargestellten Maskierungsschicht 18, z.B. aus Siliziumni-

0075103

VPA 81 P 7123 E

trid ($Si_3N_4$) oder aus $SiO_2$, bedeckt, in der für jeden
der herzustellenden Thyristoren vier streifenförmige Ausnehmungen 19 beispielsweise mittels an sich bekannter
fotolithografischer Verfahrensschritte vorgesehen werden.
Während die genannten Grenzflächen von 17 {100}-orientiert
sind, liegen die Längsachsen der streifenförmigen Ausnehmungen 19 innerhalb der in Fig. 2 sichtbaren Grenzfläche jeweils in ⟨110⟩-Richtungen. Dabei bilden jeweils
vier Ausnehmungen 19 ein Quadrat oder ein Rechteck, wobei
eine Mehrzahl dieser Quadrate bzw. Rechtecke auf der oberen Grenzfläche des Halbleiterkörpers 17 so in Zeilen
und Spalten angeordnet sind, daß zwischen ihnen schmale
Streifen 20 der Maskierungsschicht 18 bestehen bleiben.
Sämtliche Ausnehmungen 19 bilden dabei eine unterbrochene
oder auch ununterbrochene Gitterstruktur, wie bei 19a
angedeutet ist. Anschließend wird der Halbleiterkörper 17
einem Ätzvorgang mit einem anisotrop ätzenden Medium
unterzogen, das z.B. aus einer wässrigen Lösung von KOH
besteht, die auf etwa $80^{o}C$ erwärmt ist. Unterhalb der
Ausnehmungen 19 entstehen dabei V-förmige Gräben 13,
deren Tiefe T bei Vernachlässigung der sich ergebenden
Unterätzungen 21 zu der Breite B der Ausnehmungen 19 in
folgender Beziehung steht:

$$T = \frac{1}{\sqrt{2}} \cdot B$$

Die Wandungen der Gräben 13 bestehen aus 111-orientierten
Halbleiterflächen des Körpers 17.

Die Maskierungsschicht 18 wird sodann beispielsweise
mittels einer Plasma-Ätzung entfernt. Durch die Gräben
13, deren Tiefe $T \geq \frac{B}{\sqrt{2}}$ dem Abstand des pn-Übergangs 14 zwischen den Schichten 4 und 5 von der Grenzfläche 22 des
Körpers 17 entspricht oder diese übersteigt, sind die
den einzelnen Thyristoren zugeordneten, für die Thyri-

0075103

storfunktionen relevanten Teile des Halbleiterkörpers 17 elektrisch voneinander getrennt. Es können die Kathoden 7, Anoden 9 und Zündelektroden 12 der einzelnen Thyristoren aufgebracht werden und die einzelnen Thyristorsysteme hinsichtlich ihrer elektrischen Kennwerte mittels angeschlossener Meßeinrichtungen einzeln überprüft werden.

Die Trennung der einzelnen Thyristoren oder einzelner Thyristorgruppen voneinander erfolgt dadurch, daß der Halbleiterkörper entlang den Linien 22 zerteilt wird. Dies geschieht beispielsweise durch Sägen oder mittels eines Laserstrahls hinreichend großer Energie, der in an sich bekannter Weise nacheinander auf alle Punkte der Oberfläche des Körpers 17 gerichtet wird, die auf den Linien 22 liegen.

9 Patentansprüche

3 Figuren

0075103

## Patentansprüche

1. Thyristor mit einem Mehrschichten-Halbleiterkörper
mit pnpn-Schichtfolge, der zwei Grenzflächen besitzt, die
zu den pn-Übergängen zwischen den einzelnen Schichten im
wesentlichen parallel liegen und dessen Rand einen weniger als 90° betragenden Winkel mit der Grenzfläche einschließt, die die außenliegende p-Schicht abschließt,
dadurch g e k e n n z e i c h n e t , daß die Grenzflächen (6, 8) eine {100}-Orientierung aufweisen, daß von
einer derselben (6) ausgehende, V-förmige Gräben (13)
vorgesehen sind, die jeweils in ⟨110⟩-Richtungen verlaufen, daß die Gräben (13) eine solche Tiefe (T) aufweisen, daß sie wenigstens einen der von der zuletzt genannten Grenzfläche (6) weiter entfernten pn-Übergänge
(23, 14) zwischen den Schichten (3 bis 5) erreichen oder
unterbrechen, und daß die Wandungen der V-förmigen Gräben (13) aus {111}-orientierten Halbleiterflächen bestehen.

2. Verfahren zum Herstellen eines Thyristors nach Anspruch 1, dadurch g e k e n n z e i c h n e t , daß
ein monokristalliner, scheibenförmiger Mehrschichten-
Halbleiterkörper (17) mit einer pnpn-Schichtfolge und
mit zwei einander gegenüberliegenden, {100}-orientierten
und zu den pn-Übergängen zwischen den einzelnen Schichten (2 bis 5) im wesentlichen parallelen Grenzflächen
verwendet wird, die jeweils mit einer Maskierungsschicht
(18) bedeckt werden, daß in einer dieser Grenzflächen
(22a) parallel zu den ⟨110⟩-Richtungen verlaufende streifenförmige Ausnehmungen (19) vorgesehen werden, die einen
dem Thyristor zugeordneten Grenzflächenanteil zwischen
sich einschließen, daß mittels eines anisotrop wirkenden
Ätzmittels im Bereich der Ausnehmungen (19) V-förmige
Gräben (13) in den scheibenförmigen Mehrschichten-Halbleiterkörper (17) geätzt werden, deren Tiefe (T) so be-

0075103

messen ist, daß sie wenigstens einen der von der zuletzt genannten Grenzfläche (22a) weiter entfernten pn-übergänge (23, 14) zwischen den Schichten (3 bis 5) erreichen oder unterbrechen, daß die Maskierungsschichten (18) entfernt werden und daß der aus einem Teil des scheibenförmigen Mehrschichten-Halbleiterkörpers (17) bestehende Halbleiterkörper (1) des Thyristors jeweils in den äußeren Randbereichen der Gräben (13) oder außerhalb derselben (22) von dem verbleibenden Teil des scheibenförmigen Mehrschichten-Halbleiterkörpers (17) abgetrennt wird.

3. Verfahren nach Anspruch 2, dadurch g e k e n n - z e i c h n e t , daß die Ausnehmungen (19) in Form eines parallel zu den $\langle 110 \rangle$-Richtungen orientierten Gitters vorgesehen werden, das eine Mehrzahl von Grenzflächenanteilen definiert, die einer Mehrzahl von Thyristoren zugeordnet sind, und daß die Halbleiterkörper einzelner oder mehrerer nebeneinander liegender Thyristoren in den äußeren Randbereichen der sie umgebenden Gräben (13) oder außerhalb derselben vom scheibenförmigen Mehrschichten-Halbleiterkörper (17) abgetrennt werden.

4. Verfahren nach Anspruch 2 oder 3, dadurch g e - k e n n z e i c h n e t , daß der scheibenförmige Mehrschichten-Halbleiterkörper (17) aus Silizium besteht.

5. Verfahren nach Anspruch 4, dadurch g e k e n n - z e i c h n e t , daß die Maskierungsschicht (18) aus $Si_3N_4$ besteht.

6. Verfahren nach Anspruch 4, dadurch g e k e n n - z e i c h n e t , daß die Maskierungsschicht (18) aus $SiO_2$ besteht.

0075103 VPA 81 P 7123 E

7. Verfahren nach einem der Ansprüche 2 bis 6, dadurch g e k e n n z e i c h n e t , daß als Ätzmittel eine Lösung aus Kaliumhydroxid verwendet wird.

8. Verfahren nach einem der Ansprüche 2 bis 7, dadurch g e k e n n z e i c h n e t , daß die V-förmigen Gräben (13) mit einer Passivierungsmasse (16), insbesondere Kautschuk, aufgefüllt werden.

9. Verfahren nach Anspruch 2 oder 3, dadurch g e - k e n n z e i c h n e t , daß die Abtrennung der (des) Thyristor-Halbleiterkörper(s) vom scheibenförmigen Mehrschichten-Halbleiterkörper (17) durch Sägen erfolgt.

FIG 1

FIG 2

FIG 3